# EUROPÄISCHE PATENTSCHRIFT

(11) **EP 3 061 129 B1**
(45) Veröffentlichungstag und Bekanntmachung des Hinweises auf die Patenterteilung: **31.01.2018**
(21) Anmeldenummer: 14789998.3
(22) Anmeldetag: 24.10.2014
(51) Int. Cl.: H01L 23/473, G01F 1/44, F28F 3/12, F28F 13/08, F28F 27/02, F28D 7/08

(54) **KÜHLVORRICHTUNG FÜR LEISTUNGSELEKTRONISCHE BAUTEILE**
COOLING DEVICE FOR POWER ELECTRONIC COMPONENTS
DISPOSITIF REFROIDISSEUR POUR COMPOSANTS ÉLECTRONIQUES DE PUISSANCE

(30) Priorität: 25.10.2013 DE 102013017812
(43) Veröffentlichungstag der Anmeldung: 31.08.2016
(73) Patentinhaber: Liebherr-Components Biberach GmbH, 88400 Biberach an der Riß (DE)
(72) Erfinder: SCHUSTER, Wolfgang, 88339 Bad Waldsee (DE)
(74) Vertreter: Thoma, Michael
(86) Internationale Anmeldenummer: PCT/EP2014/002874
(87) Internationale Veröffentlichungsnummer: WO 2015/058859

(56) Entgegenhaltungen:
- EP-A1- 0 524 757
- DE-U1- 9 315 513
- US-A1- 2003 085 024

## Beschreibung

Die vorliegende Erfindung betrifft eine Kühlvorrichtung für leistungselektronische Geräte, mit zumindest einem Kühlkörper in Form einer Kühlplatte, die mit zumindest einem zu kühlenden leistungselektronischen Bauteil in Berührung steht, sowie einer von einem Kühlmittel durchströmbaren, durch die nKühlplatte führenden Kühlmittelleitung, wobei Durchfluss-Bestimmungsmittel zum Bestimmen der durch den Kühlkörper strömenden Durchflussmenge vorgesehen sind.

Leistungselektronische Bauelemente und Geräte wie Leistungshalbleiter und Frequenzumformer oder Computerkomponenten wie Prozessoren und dergleichen werden häufig mit Kühlkörpern in Form von Kühlplatten gekühlt, in denen eine Kühlmittelleitung vorgesehen, beispielsweise mäanderförmig ausgeformt ist, um ein geeignetes Kühlmittel beispielsweise in Form einer Flüssigkeit wie Wasser, flüssiger Stickstoff oder dergleichen durch die Kühlplatte leiten zu können. Die leistungselektronischen Bauteile stehen mit der Kühlplatte in Berührung, um ihre Wärme in die Kühlplatte abgeben zu können, von der sie dann durch das durchströmende Kühlmedium abtransportiert wird. Die zu kühlenden Bauteile können dabei unmittelbar auf die Kühlplatte montiert sein oder unter Zwischenschaltung einer oder mehrerer Zwischenschichten wie beispielsweise einer die Wärmeleitung und/oder den Wärmeübergang verbessernden Zwischenschicht beispielsweise in Form einer Leitpaste mit der Kühlplatte verbunden sein, so daß die vorgenannte Berührung unmittelbar oder mittelbar sein kann.

Solche Kühlvorrichtungen für leistungselektronische Bauteile sind beispielsweise aus der Schrift DE 20 2006 012 950 U1 oder DE 20 2012 001 323 U1 bekannt, wobei letztere eine Kühlplatte mit einem Zulauf und einem Ablauf zeigt, die mit im Inneren der Platte ausgebildeten Kühlmittelleitungsabschnitten und -taschen in Strömungsverbindung stehen. Die Schrift DE 10 2006 040 187 B4 zeigt eine ähnliche Kühlvorrichtung für leistungselektronische Bauteile, wobei hier mehrere Kühlmodule an gemeinsamen Zuflussverteilern und Abflusssammlern zusammengefasst sind.

Aus der Schrift US 2003/0085024 A1 ist eine Kühlvorrichtung für Elektronikgeräte wie Laptops bekannt, die mittels einer elektroosmotischen Pumpe Kühlmittel durch Elektronikkomponenten des Geräts fördert. Ferner beschreibt die Druckschrift DE 93 15 513 U1 eine Einrichtung zur Erfassung eines Abgasvolumenstroms eines gasbetriebenen Wasserheizers, wobei ein in der Abgasleitung angeordneter Sensor durch eine Venturidüse gebildet ist, an deren Verengung ein mit Flüssigkeit gefülltes U-förmiges Rohr senkrecht zur Strömungsrichtung mit einem ersten Schenkel angeschlossen ist, wobei der zweite Schenkel des besagten Rohrs an einem unverengten Abschnitt der Abgasleitung angeschlossen ist.

Um die Kühlwirkung solcher Kühlplatten und damit den Wärmeabtransport der relativ temperaturempfindlichen leistungselektronischen Komponenten exakt steuern zu können, ist es hilfreich, die durch eine Kühlplatte strömende Durchflussmenge des Kühlmittels exakt zu kennen und entsprechend steuern zu können. Zur Bestimmung der Durchflussmenge durch eine Kühlplatte können Durchflussmesser in die Flüssigkeitsleitung eingebaut bzw. daran angebaut werden, wobei bei Verwendung mehrere Kühlplatten üblicherweise mehrere solcher Durchflusssensoren verwendet werden. Solche Durchflussmesser beispielsweise in Form von Ultraschallsensoren sind jedoch relativ teuer, so dass bei komplexeren Kühlvorrichtungen hohe Kosten anfallen. Zum anderen sind die Kühlplatten dabei oft recht eng mit den zu kühlenden Elektronikbauteilen bestückt, so daß zum Anschließen der genannten Durchflusssensoren bisweilen nur wenig bis gar kein Platz besteht.

Der vorliegenden Erfindung liegt die Aufgabe zugrunde, eine verbesserte Kühlvorrichtung der eingangs genannten Art zu schaffen, die Nachteile des Standes der Technik vermeidet und Letzteren in vorteilhafter Weise weiterbildet. Insbesondere soll eine verbesserte, präzise Bestimmung der Durchflussmenge mit einer einfachen, kostengünstigeren und möglichst platzsparenden Sensorik ermöglicht werden.

Erfindungsgemäß wird die genannte Aufgabe durch eine Kühlvorrichtung gemäß Anspruch 1 gelöst. Bevorzugte Ausgestaltungen der Erfindung sind Gegenstand der abhängigen Ansprüche.

Es wird vorgeschlagen, die Durchflussmenge nicht mehr mittels mehrerer Durchflussmesser zu bestimmen, sondern die Druckdifferenz an zwei geeigneten Stellen der Kühlmittelleitung, die durch den Kühlkörper führt, zu bestimmen und aus der genannten Druckdifferenz die Durchflussmenge zu bestimmen. Erfindungsgemäß besitzt die Kühlmittelleitung in der Kühlplatte eine Querschnittsverjüngung, wobei zumindest zwei Messanschlüsse zum Anschließen eines Differenzdruckmessers zum Messen einer Druckdifferenz an den beide Messanschlüssen vorgesehen sind, von denen einer an oder unmittelbar stromab der genannten Querschnittsverjüngung an der Kühlplatte vorgesehen ist. Die Durchfluss-Bestimmungsmittel umfassen dabei eine Auswerteeinrichtung zum Ermitteln der Durchflussmenge aus der gemessenen Druckdifferenz. Da die Geometrie der Kühlmittelleitung im Allgemeinen und insbesondere auch im Bereich zwischen den beiden Messanschlüssen und auch die Eigenschaften des verwendeten Kühlmittels wie beispielsweise Viskosität bekannt sind, kann die Auswerteeinrichtung aus der gemessenen Druckdifferenz an der Querschnittsverjüngung in der Kühlplatte die Durchflussmenge durch die Kühlplatte mit hoher Genauigkeit bestimmen. Die Druckmessung un die hierfür vorgesehen Drucksensorik ist wesentlich kostengünstiger als Durchflussmesser, wobei sich durch das Vorsehen der beiden Messanschlüsse auch die Gestaltung der Kühlplatte an sich einfach halten lässt.

In Weiterbildung der Erfindung kann die Flüssigkeitsleitung zwischen den beiden Messanschlüssen eine Querschnittsverjüngung in Form eines Venturielements aufweisen. Ein solches Venturielement kann eine düsenförmige Rohr- bzw. Leitungsverjüngung umfassen, wobei sich an der engsten Stelle der Leitung, d.h. dort, wo der Querschnitt am engsten ist und die Strömungsgeschwindigkeit am höchsten ist, der geringste Druck einstellt. An der Engstelle der Venturidüse wird der dynamische Druck maximal und der statische Druck minimal, wenn durch die Venturidüse das flüssige Kühlmedium strömt. Vorteilhafterweise kann bei Verwendung einer solchen Querschnittsverjüngung bzw. eines Venturielements die Engstelle nach der Verjüngung und die breite Stelle vor der Verjüngung mittels jeweils eines' Messanschlusses angezapft werden, um mittels des Differenzdrucksensors die sich über die Querschnittsverjüngung einstellende Druckdifferenz zu bestimmen.

Insbesondere kann das Venturielements eine beispielsweise zylindrische oder zumindest rotationssymmetrische oder in anderer Weise geformte Engstelle bilden, an die stromauf und stromab sich im Durchmesser kontinuierlich verändernde Einlauf- und Auslaufabschnitte anschließen. Die genannten Einlauf- und Auslaufabschnitte können vorteilhafterweise rotationssymmetrisch ausgebildet sein und harmonisch geformte Verjüngungs- bzw. Aufweitabschnitte bilden, die den Durchmesser und/oder den Querschnitt der Engstelle sanft übergehend, stetig bzw. harmonisch fortsetzeen können. Beispilesweise können die genannten Einlauf- und Auslaufabschnitte jeweils konisch konturiert sein und stufenfrei an die Engstelle anschließen. Das Vernturielement kann vorzugsweise eine harmonisch geformte Venturidüse bilden.

In Weiterbildung der Erfindung kann einer der Messanschlüsse an der Engstelle des Venturielements vorgesehen, während ein anderer Messanschluß stromauf des Einlaufabschnitts des Venturielements, insbesondere in einem noch unverjüngten Abschnitt der Kühlmittelleitungin der Kühlplatte unmittelbar stromauf des Einlaufabschnitts, angeordnet sein kann.

Um eine düsenförmige Querschnitttsveränderung nicht nur auf einer, sondern auf beiden Seiten der Engstelle des Venturielements mit vernünftigem Fertigungsaufwand vorsehen zu können, kann das Venturielement ein von der Kühlplatte separat gefertigtes Einsatzteil bilden, das in die Kühlplatte einsetzbar ist und im eingesetzten Zustand in der Kühlplatte einen Teil der Kühlmittelleitung durch die Kühlplatte bildet. Vorteilhafterweise kann das Venturielement ein in Längsrichtung der Kühlmittelleitung in die Kühlplatte einsetzbares Einsatzteil bilden, das beispielsweise von einer Mündung der Kühlmittelleitung an einer Kühlplattenseite her in diese einschiebbar und/oder einschraubbar ist. Das Venturielement kann eine Einsatzhülse bilden.

Bei Verwendung einer Venturidüse kann ein Drucksensor vor der Düse und ein Drucksensor im engen Teil des Venturikanals vorgesehen bzw. angeschlossen werden. Da dort die Fließgeschwindigkeit hoch ist, sinkt gemäß der bekannten Bernoulligleichung am Venturirohrder der Wanddruck dort stark ab . Ein Vorteil der Venturilösung ist insofern, dass die Druckdifferenz an den beiden Drucksensoren deutlich größer ist als bei bloßer Verwendung einer Stauscheibe oder einer stufenförmigen Querschnittsverjüngung. Bei gleichem Druckverlust der gesamten Messeinrichtung hat die Messung mit der Venturidüse ein wesentlich größeres Messsignal und damit eine bessere Auflösung. Der Venturikanal ist für eine genaue Messung vorteilhafterweise turbulenzarm gestaltet, insbesondere durch einen harmonischen, sanften Verlauf der Querschnittsänderungen frei von scharfen Ecken oder Stufen.

Um eine turbulenzarme Gestaltung des Venturikanals zu erleichtern, kann eine externe Fertigung der Venturidüse auf einer Drehmaschine erfolgen. Der Kanal kann dabei durchgehend rotationssymmetrisch geformt werden und es können sowohl der Einlauf als auch der Auslauf der Engstelle mit einer Schräge ausgeführt werden, um eine laminare Strömung zu erhalten. Dies erhöht die Genauigkeit der Messeinrichtung deutlich. Mit einer reinen Fräsung im Kühlkörper von der Oberseite her können die Querschnitte nicht wirklich rotationssymmetrisch gefertigt werden und man erhält höhere Turbulenzen. Die Verwendung eines Stufenbohrer brächte schon eine bessere Annäherung an das Ziel, schafft es aber kaum bzw. nur sehr schwierig, hinter dem engen Kanal eine rotationssymmetrische Aufweitung zu erreichen.

Vorteilhafterweise kann der Differenzdruckmesser nicht aus einem Differenzdrucksensor bestehen, der an sich recht teuer und unhandlich ist, sondern zwei an die Messansschlüsse anschließbare Drucksensorelemente umfassen, die mit der Auswerteeinrichtung verbindbar sind, wobei die Auswerteeinrichtung Druckdifferenz-Bestimmungsmittel zum Bestimmen der genannten Druckdifferenz Δ P aus den Signalen der beiden Drucksensorelemente aufweist.

Dabei können die Drucksensorelemente ohne Zwischenschaltung einer Verschlauchung unmittelbar an der Kühlplatte oder einem an der Kühlplatte starr befestigten Sensorhalter montiert und befestigt sein. Hierdurch kann eine exakte Messung erreicht und zusätzliche Bauteile mit entsprechendem Platzbedarf vermieden werden.

Unabhängig vom Vorsehen der genannten Querschnittsverjüngung kann es grundsätzlich vorteilhaft sein, die Messanschlüsse direkt am Kühlkörper vorzusehen, um eine kompakte Anordnung und unmittelbare Messung am Kühlkörper zu ermöglichen. Notwendig ist dies jedoch nicht, es könnte eine entsprechende Verjüngung oder das Anzapfen über die Messanschlüsse auch an einem Kühlmittelleitungsabschnitt außerhalb des Kühlkörpers vorgesehen sein.

Werden mehrere Kühlkörper jeweils vorzugsweise in Form von Kühlplatten verwendet, die jeweils von einer Kühlmittelleitung durchzogen sind, können zumindest einige der Kühlkörper mit ihren Zuläufen an einem gemeinsamen Zulaufverteiler angeschlossen sein und/oder mit ihren Abläufen an einem gemeinsamen Ablaufsammler angeschlossen sein, um die Verrohrung bzw. Verlegung der Leitungen einfach zu gestalten und die weitere Handhabung der Kühlflüssigkeit bzw. des Kühlmittels zu vereinfachen.

Bei solchen mehreren, an einem gemeinsamen Zulaufverteiler angeschlossenen Kühlkörpern kann es in Weiterbildung der Erfindung vorteilhaft sein, einen gemeinsamen Messanschluss im Bereich des genannten Zulaufverteilers vorzusehen, wodurch die Anzahl der insgesamt vorzusehenden Messanschlüsse deutlich reduziert werden kann. An den Kühlkörpern selbst braucht lediglich nur ein Messanschluss vorgesehen sein - obwohl natürlich grundsätzlich auch dort mehrere Messanschlüsse vorgesehen werden könnten - , wobei ein solcher Messanschluss am jeweiligen Kühlkörper vorteilhafterweise stromab der zuvor beschriebenen Querschnittsverjüngung vorgesehen sein kann. Jede der Kühlplatten kann dabei vorzugsweise die genannte Querschnittsverjüngung insbesondere in Form eines Venturielements aufweisen.

Bei einer solchen Anordnung kann der Differenzdruckmesser vorzugswesie in Form der beiden Drucksensoren einerseits an der gemeinsamen Messstelle am Zulaufverteiler und andererseits an der jeweiligen Messstelle des jeweiligen Kühlkörpers angeschlossen sein, um den Differenzdruck zwischen dem Zulaufverteiler und der Messstelle am Kühlkörper zu bestimmen und hieraus dann die Durchflussmenge durch den jeweiligen Kühlkörper bestimmen zu können. Vorteilhafterwesie können an den Kühlplatten selbst auch jeweils zwei Messanschlüsse vorgesehen sein, die in der genannten Weise der jeweiligen Querschnittsverjüngung zugeordnet sein können, um eine erhöhte Messgenauigkeit zu erhalten.

Sind die genannten mehreren Kühlkörper der Kühlvorrichtung - oder zumindest eine Untergruppe dieser mehreren Kühlkörper - sowohl zulaufseitig an einem gemeinsamen Zulaufverteiler und ablaufseitig an einem gemeinsamen Ablaufsammler angeschlossen bzw. zusammengefasst, kann es in Weiterbildung der Erfindung vorteilhaft sein, neben der zuvor genannten Messstelle am Zulaufverteiler auch einen Messanschluss am Ablaufsammler vorzusehen, so dass der Differenzdrucksensor die Druckdifferenz zwischen Zulaufverteiler und Ablaufsammler bestimmen kann. Unter Berücksichtigung des jeweils einen zusätzlichen Messanschlusses an den Kühlkörpern kann unter Berücksichtigung der gesamten Druckdifferenz zwischen Zuflussverteiler und Abflusssammler und den einzelnen Drücken an den einzelnen Kühlkörpern, insbesondere stromab des zuvor genannten Venturielements bzw. der zuvor genannten Querschnittsverjüngung, die gesamte Durchflussmenge durch die Mehrzahl der Kühlkörper und/oder die Teildurchflussmenge durch einen einzelnen Kühlkörper bestimmt werden. Beispielsweise kann aus einem individuellen Druckwert, der an dem einen zusätzlichen Druckanschluss an einem Kühlkörper gemessen wird, der Anteil dieses Kühlkörpers am gesamten Druckabfall bestimmt und hieraus die Durchflussmenge durch diesen einen Kühlkörper bestimmt werden.

Um eine einfache Anbindung der Drucksensoren an die Kühlplatte bzw. die daran vorgesehenen Messanschlüsse zu ermöglichen, können die genannten Messanschlüsse Steck- und/oder Schraubverbindungen aufweisen, um die Drucksensoren einfach durch Anstecken bzw. Anschrauben anbinden zu können. Vorteilhafterweise sind die genannten Messanschlüsse dabei lösbar ausgebildet, so dass der jeweilige Drucksensor einfach angeschlossen und gelöst werden kann.

Die Druckmesser können vorteilhafterweise ohne Zwischenschaltung von Schläuchen direkt an eine jeweilige Kühlplatte bzw. ein daran starr befestigtes Anschlußelement angeschlossen werden.

In vorteilhafter Weiterbildung der Erfindung wird bei der Bestimmung der Durchflussmenge auch die Temperatur des Kühlmittels und/oder die Temperatur des Kühlkörpers berücksichtigt, um temperaturabhängige Veränderungen der Durchflussmenge berücksichtigen zu können, beispielsweise durch temperaturabhängige Viskositätsänderungen des Kühlmittels und/oder durch thermische Materialdehnungen verursachte Veränderungen der Kühlmittelleitungsquerschnitte. In vorteilhafter Weiterbildung der Erfindung kann an dem oder in dem Kühlkörper zumindest ein Temperatursensor vorgesehen sein, wobei bei Verwendung mehrerer Kühlkörper in Weiterbildung der Erfindung jeder Kühlkörper zumindest einen Temperatursensor aufweisen kann. Dabei kann in vorteilhafter Weiterbildung der Erfindung ein Temperaturmessfühler am Kühlkörper vorgesehen sein, der über eine Signalleitung mit dem zuvor genannten Auswertegerät bzw. der Auswerteeinheit verbunden sein kann, so dass in der Auswerteeinheit einerseits die Druckwerte und andererseits die Temperaturwerte zusammenlaufen.

Die Auswerteeinheit kann vorteilhafterweise mit einer übergeordneten Steuerung verbunden sein, die beispielsweise weitere Komponenten der Kühlvorrichtung steuern kann, insbesondere in Abhängigkeit der erfassten Durchflussmenge. Beispielsweise kann eine Kühlmittelpumpe in Abhängigkeit der bestimmten Durchflussmenge angesteuert werden, um die Durchflussmenge auf einen Sollwert einzuregeln. Alternativ oder zusätzlich kann ein Lüfter in Abhängigkeit der bestimmten Durchflussmenge und/oder der gemessenen Temperatur angeschaltet oder abgeschaltet werden. Alternativ oder zusätzlich können über Ventile zusätzliche Kühlkörper zugeschaltet oder zusätzliche Kühlkreise durch In-Gang-Setzen einer Kühlmittelpumpe gestartet werden, wobei je nach Ausbildung der Kühlvorrichtung auch andere Parameter der Kühlvorrichtung von der genannten übergeordneten Steuerung variiert werden können.

In vorteilhafter Weiterbildung der Erfindung kann die Auswerteeinheit über ein Bussystem, beispielsweise einem Feldbus oder eine andere Kabelverbindung mit der übergeordneten Steuerung verbunden sein.

Die Erfindung wird nachfolgend anhand bevorzugter Ausführungsbeispiele und zugehöriger Zeichnungen näher erläutert. In den Zeichnungen zeigen:

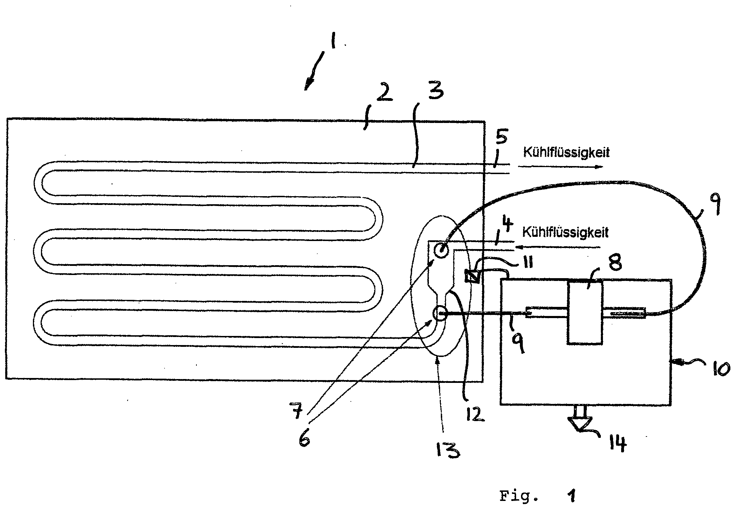

- Fig. 1:: eine schematische Darstellung einer Kühlvorrichtung mit einem Kühlkörper, der von einer Kühlmittelleitung durchzogen ist, wobei die Kühlmittelleitung im Kühlkörper eine Querschnittsverjüngung und zwei zugeordnete Messanschlüsse aufweist, über die Drucksensoren zum Bestimmen einer Druckdifferenz an die Kühlmittelleitung anschließbar sind,

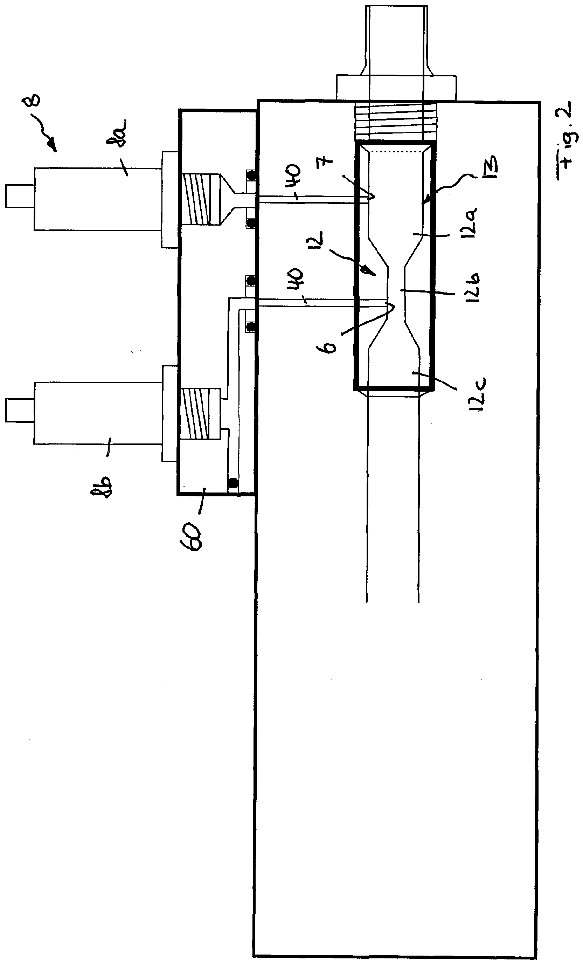

- Fig. 2:: eine schematische Darstellung einer Kühlvorrichtung mit einem Kühlkörper ähnlich Fig. 1, wobei die Kühlmittelleitung in dem Kühlkörper eine Querschnittsverjüngung in Form eines Venturielements aufweist und die Messanschlüsse für die Drucksensor stromauf und stromab des Venturielements vorgesehen sind, wobei die Drucksensoren direkt an die Kühlplatte montiert sind,

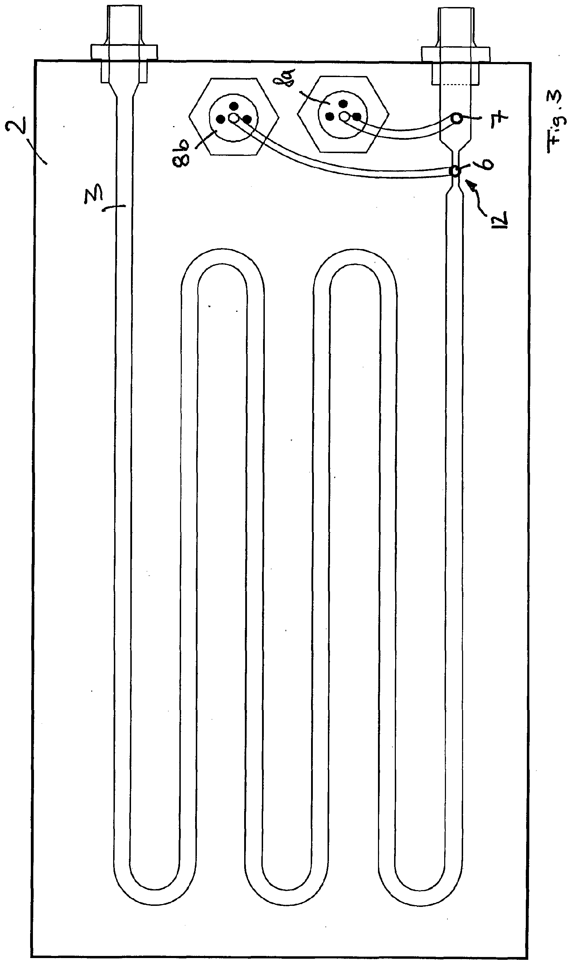

- Fig. 3:: eine Draufsicht auf die Kühlplatte aus Figur 2, die die Anordnung der Drucksensoren zeigt,

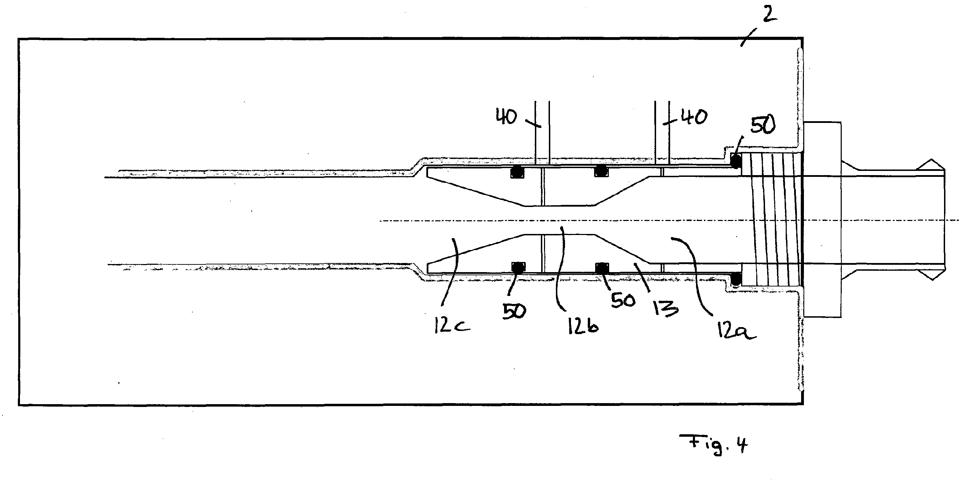

- Fig. 4:: eine ausschnittweise, vergrößete Darstellung der als Einsatzteil ausgebildeten Venturielemts, das im Inneren der Kühlplatte die genannte Querschnittsverjüngung bildet,

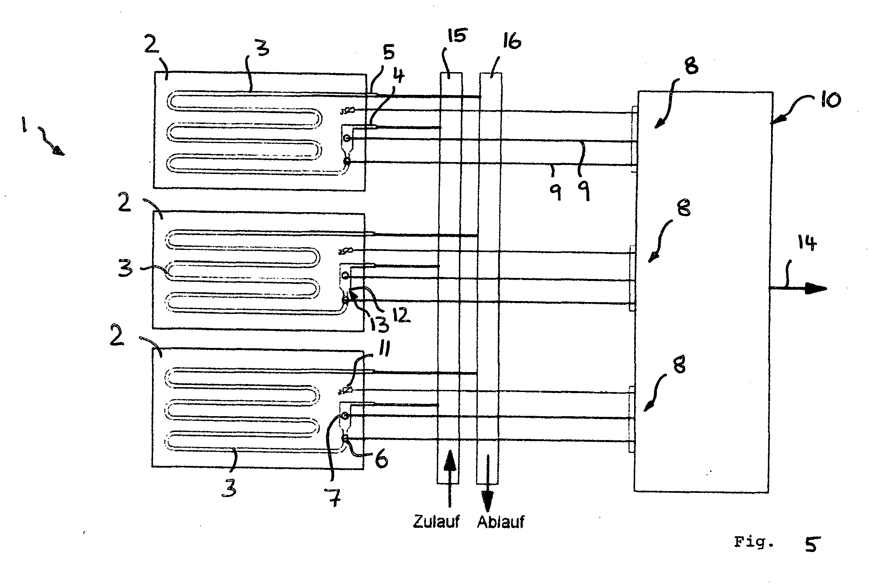

- Fig. 5:: eine schematische Darstellung einer Kühlvorrichtung mit mehreren Kühlkörpern, die mit ihren Zuläufen an einem gemeinsamen Zulaufverteiler und mit ihren Abläufen an einem gemeinsamen Ablaufsammler angeschlossen sind, wobei die Kühlmittelleitungen in den Kühlkörpern jeweils eine Querschnittsverjüngung in Form eines Venturielements besitzen und die Messanschlüsse für den Differenzdrucksensor jeweils stromauf und stromab des genannten Venturielements angeordnet sind, so dass für jeden Kühlkörper separat die Druckdifferenz und hieraus die Durchflussmenge bestimmbar ist,

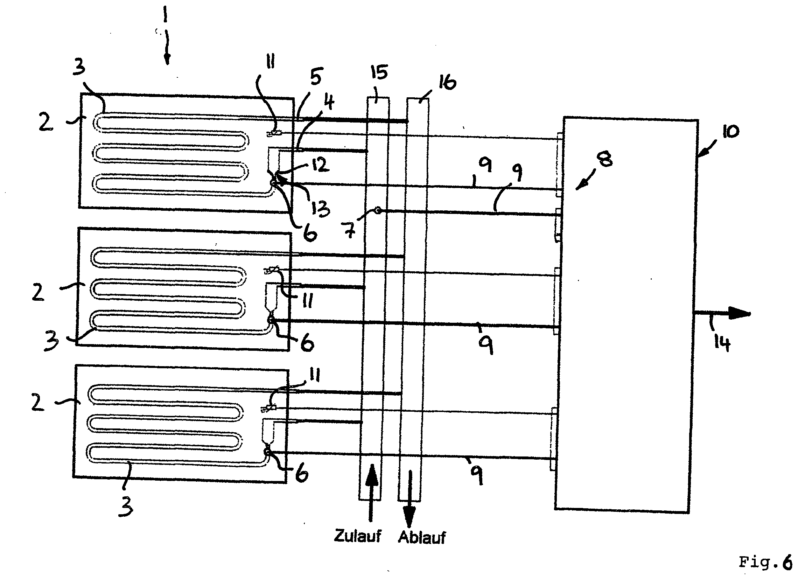

- Fig. 6:: eine schematische Darstellung einer Kühlvorrichtung mit mehreren Kühlkörpern ähnlich Fig. 5, wobei auch hier die mehreren Kühlkörper mit ihren Zuläufen an einem gemeinsamen Zulaufverteiler und mit ihren Abläufen an einem gemeinsamen Ablaufsammler angeschlossen sind, wobei jeder Kühlkörper nur einen Messanschluss, insbesondere an der Engstelle des Venturielements aufweist, während eine gemeinsame Messstelle stromauf des Venturielements für alle Kühlkörper im Bereich des Zulaufverteilers vorgesehen ist, und

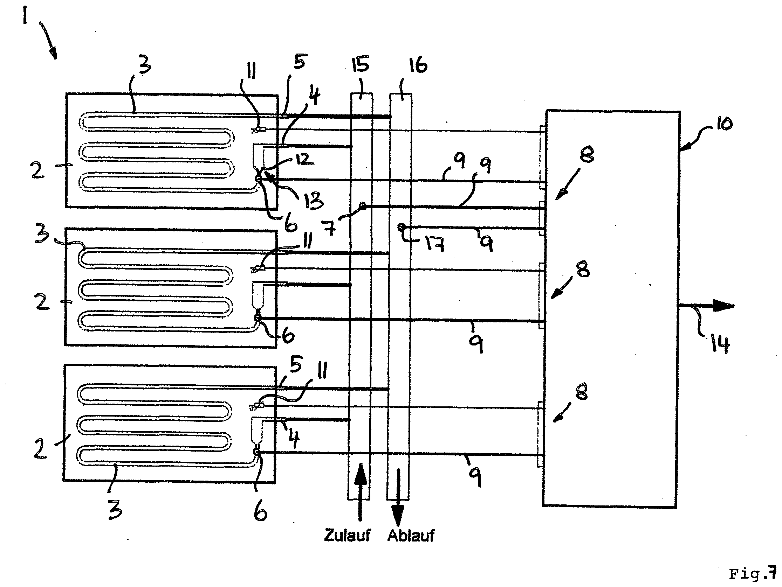

- Fig. 7:: eine schematische Darstellung einer Kühlvorrichtung mit mehreren Kühlkörpern ähnlich den Figuren 5 und 6, wobei auch hier die mehreren Kühlkörper mit ihren Zuläufen an einem gemeinsamen Zulaufverteiler und mit ihren Abläufen an einem gemeinsamen Ablaufsammler angeschlossen sind, wobei an dem Zulaufverteiler und an dem Ablaufsammler jeweils ein Messanschluss für den Differenzdrucksensor vorgesehen ist und an jedem Kühlkörper ein weiterer Messanschluss, insbesondere an der Engstelle des Venturielements, vorgesehen ist.

Wie Fig. 1 zeigt, kann die Kühlvorrichtung 1 einen Kühlkörper 2 in Form einer Kühlplatte oder eines ähnlichen flachen, langgestreckten Körpers aufweisen, durch den eine Kühlmittelleitung 3 führt. Die Kühlmittelleitung 3 könnte grundsätzlich nach Art einer Aufputzleitung auf die Oberfläche des Kühlkörpers gesetzt sein. In vorteilhafter Weiterbildung der Erfindung kann die Kühlmittelleitung 3 durch das Innere des Kühlkörpers 2 führen bzw. in den Kühlkörper 2 integriert bzw. eingearbeitet sein, wobei der Kühlkörper 2 einen Zulaufanschluss 4 und einen Ablaufanschluss 5 besitzen kann, die mit der genannten Kühlmittelleitung 3 in Verbindung stehen und beispielsweise durch aus dem Kühlkörper 2 herausstehenden Enden der genannten Kühlmittelleitung 3 oder an den Kühlmittelkörper 3 angeformte Anschlussstutzen gebildet sein können.

Wie Fig. 1 zeigt, kann sich die Kühlmittelleitung 3 mäanderförmig durch den Kühlmittelkörper schlängeln, ggf. aber auch in anderer Weise durch den Kühlkörper 2 hindurchgeführt sein, um eine ausreichende Leitungslänge im Kühlmittelkorpus zu realisieren.

Wie Fig. 1 zeigt, können vorteilhafterweise im Bereich des Kühlkörpers 2 in ausreichendem Abstand voneinander zwei Messanschlüsse 6 und 7 vorgesehen sein, über die die Kühlmittelleitung angezapft werden kann. Über die genannten Messanschlüsse 6 und 7 kann ein Differenzdruckmesser 8 angeschlossen werden, wobei dies beispielsweise über Messschläuche 9 erfolgen kann, die den Differenzdrucksensor 8 mit dem jeweiligen Messanschluss 6 bzw. 7 verbinden.

In vorteilhafter Weiterbildung der Erfindung können die genannten Messanschlüsse 6 und 7 sowie die Messschläuche 9 als Pneumatikteile ausgebildet sein.

Gegebenenfalls können aber auch hydraulische Bauteile oder andere Druckschläuche bzw. -leitungen verwendet werden.

Über den Differenzdruckmesser 8 wird der Druckabfall über die Strecke bzw. den Kühlmittelleitungsabschnitt zwischen den beiden Messanschlüssen 6 und 7 bestimmt, wobei aus dieser Druckdifferenz von einer Auswerteeinrichtung 10 anhand der bekannten Geometrie der Kühlmittelleitung und eventuell weiteren Parameter wie der Viskosität des Kühlmittels und/oder der Temperatur des Kühlmittels bzw. des Kühlkörpers 2 die Durchflussmenge durch den Kühlkörper 2 bestimmt werden kann.

Wie Fig. 1 zeigt, kann die Kühlmittelleitung 3 in dem Kühlkörper 2 zwischen den Messanschlüssen 6 und 7 vorteilhafterweise eine Querschnittsverjüngung 12 aufweisen. Vorteilhafterweise sind die Messanschlüsse 6 und 7 bei Vorhandensein einer solchen Querschnittsverjüngung 12 einerseits an der Engstelle 12b der Querschnittsverjüngung 12 bzw. stromab der Querschnittsverjüngung 12 und andererseits an einem Abschnitt großen Durchmessers bzw. großer Querschnittsfläche stromauf der Engstelle 12b vorgesehen. Insbesondere kann in Weiterbildung der Erfindung zumindest der engstellenseitige Messanschluss 6 unmittelbar an bzw. in direkter Nachbarschaft zu der genannten Querschnittsverjüngung 12, insbesondere an der engsten Leitungsstelle vorgesehen sein. Um eine kompakte Anschlussanordnung zu erzielen, kann es auch vorteilhaft sein, den stromauf der Engstelle vorgesehenen zweiten Messanschluss 7 unmittelbar stromauf der Engstelle im Bereich des großen Querschnittsabschnitts des Venturielements 13 vorzusehen.

In Weiterbildung der Erfindung kann an dem Kühlkörper 2 ein Temperatursensor 11 angebracht sein, der über eine geeignete Signalleitung mit der genannten Auswerteeinrichtung 10 verbunden sein kann.

Vorteilhafterweise kann die Auswerteeinrichtung 10 mit dem Differenzdrucksensor 8 zu einer gemeinsamen Baugruppe zusammengefasst sein, die von dem Kühlkörper 2 separat ausgebildet und durch Lösen der Messschläuche 9 und ggf. der Signalleitung zum Temperatursensor 11 vom Kühlkörper 2 getrennt werden kann. Hierzu können die Messanschlüsse 6 und 7 lösbar ausgebildet sein, beispielsweise in Form von lösbaren Steckverbindungen.

Wie Fig. 2 zeigt, kann die Querschnittsverjüngung 12 vorteilhafterweise in Form eines Venturielements 13 oder eines anderen düsenförmigen Strömungsbeschleunigers ausgebildet sein. Vorteilhafterweise sind die Messanschlüsse 6 und 7 bei Vorhandensein einer solchen Querschnittsverjüngung 12 einerseits an der Engstelle der Querschnittsverjüngung 12 bzw. stromab der Querschnittsverjüngung 12 und andererseits an einem Abschnitt großen Durchmessers bzw. großer Querschnittsfläche stromauf der Engstelle vorgesehen.

Insbesondere kann das Venturielements 13 eine Engstelle 13b aufweisen, an die stromauf und stromab sich im Durchmesser kontinuierlich verändernde Einlauf- und Auslaufabschnitte 13a, 13 c anschließen.

Dabei kann der genannte eine Messanschluss 6 an der Engstelle 13b des Venturielements 13 vorgesehen sein und ein anderer der genannten Messanschlüsse 7 stromauf des Einlaufabschnitts 13a des Venturielements 13, insbesondere in einem noch unverjüngten Abschnitt der Kühlmittelleitung 3 in der Kühlplatte unmittelbar stromauf des Einlaufabschnitts 13a angeordnet sein.

Vorteilhafterweise kann dabei vorgesedhen sein, daß das Venturielement 13 ein Einsatzteil bildet, das in die Kühlplatte einsetzbar ist und in der Kühlplatte einen Teil der Kühlmittelleitung durch die Kühlplatte bildet. Wie Fig. 2 und 4 zeigen, kann das hülsenförmige Venturi-Einsatzelement von einer Stirnseite der Kühlplatte 2 her in die Kühlmittelleitung 3 eingeschoben bzw. eingeschraubt werden, so daß die Innenausnehmung des Einsatzteils einen Teil des Kühlmittelkanals und dabei dessen düsenförmige Verjüngung bildet. Messanschlüsse können in Form von Querbohrungen oder -kanälen 40 zu dem Einsatzteil geführt sein, das mit Dichtungen 50 entsprechend gegenüber dem Kanal in der Kühlplatte abgedichtet sein kann, um den Druck an den beschriebenen Stellen abgreifen zu können.

Wie Fig. 2 und 3 zeigen, kann der Differenzdruckmesser 8 zwei an die Messansschlüsse anschließbare Drucksensorelemente 8a, 8b umfassen, die mit der Auswerteeinrichtung 10 drahtlos oder per Signalleitung verbindbar sind, wobei die Auswerteeinrichtung 10 Druckdifferenz-Bestimmungsmittel zum Bestimmen der genannten Druckdifferenz Δ P aus den Signalen der beiden Drucksensorelemente 8a, 8b aufweist.

Die Drucksensorelemente 8a, 8b sind dabei vorteilhafterweise ohne Zwischenschaltung einer Verschlauchung unmittelbar an der Kühlplatte oder einem an der Kühlplatte starr befestigten Sensorhalter beispielsweise in Form eines auf die eigentliche Kühlplatte aufgesetzten Halteflansches 60 montiert und befestigt.

Wie Fig. 1 und 2 zeigen, kann es vorteilhaft sein, die genannte Querschnittsverjüngung 12 an einem stromaufseitigen bzw. zulaufseitigen Endabschnitt der Kühlmittelleitung 3 in dem Kühlkörper 2 anzuordnen.

Wie Fig. 5 zeigt, kann die Kühlvorrichtung 1 auch mehrere Kühlkörper 2 umfassen, die jeweils ähnlich oder entsprechend dem Kühlkörper 2 gemäß Fig. 1 oder gemäß Fig. 2 - insbesondere in Form einer Kühlplatte mit integriertem Venturielement - ausgebildet sein können. Wie Fig. 5 zeigt, kann insbesondere jeder der Kühlkörper 2 eine Querschnittsverjüngung 13 in Form eines eingesetzten Venturi-Einsatzelements 13 besitzen, wobei stromauf und stromab der Engstelle 12b bzw. unmittelbar an der Engstelle 12b der Messanschluss 6 und der Messanschluss 7 vorgesehen sein können, um für jeden Kühlkörper 2 die zuvor genannte Druckdifferenz bestimmen bzw. messen zu können.

Wie Fig. 5 zeigt, können vorteilhafterweise die den Kühlkörpern 2 zugeordneten Drucksensoren 8a und 8b mit der Auswerteeinrichtung 10 zu einer zentralen Einheit bzw. einem zentralen Auswertegeräte zusammengefasst sein, wobei die Auswerteeinrichtung 10 über ein Bussystem 14 bzw. einen Bus mit einer übergeordneten, nicht eigens dargestellten Steuervorrichtung verbunden sein kann.

Die Auswerteeinrichtung 10 kann über die Anbindung der Differenzdrucksensoren 8 an die Messanschlüsse 6 und 7 der jeweiligen Kühlkörper 2 deren Durchflussmenge und aus den Durchflussmengen der einzelnen Kühlkörper 2 die gesamte Durchflussmenge des Systems bestimmen.

Wie Fig. 5 zeigt, können an den Kühlkörpern 2 jeweils Temperatursensoren 11 angebracht sein, die über Signalleitungen ebenfalls mit der Auswerteeinrichtung 10 verbunden sein können, um Temperaturabhängigkeiten bei der Bestimmung der Durchflussmengen berücksichtigen zu können.

Vorteilhafterweise können die mehreren Kühlkörper 2 mit ihren Zuläufen 4 an einem gemeinsamen Zulaufverteiler 15 angeschlossen sein und mit ihren Abläufen 5 an einem gemeinsamen Ablaufsammler 16 angeschlossen sein.

Wie Fig. 6 zeigt, kann die Zahl der Messanschlüsse an den mehreren Kühlkörpern 2 dadurch reduziert werden, dass an dem Zulaufverteiler 15 ein gemeinsamer Messanschluss 7 vorgesehen wird, während an jedem Kühlkörper 2 nur noch ein weiterer Messanschluss 6 vorgesehen ist, der vorteilhafterweise in der zuvor beschriebenen Weise an der Engstelle bzw. stromab der Engstelle der Querschnittsverjüngung 12 in der Kühlmittelleitung 3 vorgesehen sein kann. Die Auswerteeinrichtung 10 kann dabei die Druckdifferenz für jeden Kühlkörper 2 einerseits aus dem gemeinsamen, zentralen Messanschluss 7, der am Zulaufverteiler 15 vorgesehen ist, und andererseits aus dem Messanschluss 6 am jeweiligen Kühlkörper 2 bzw. den dort jeweils abgegriffenen Druckwerten bestimmen. Im Vergleich zur Ausführung nach Fig. 3 sind hierdurch anstelle von sechs Druckmessanschlüssen nur noch vier Druckmessanschlüsse notwendig.

Im Übrigen entspricht die Ausführung nach Fig. 6 der Ausführung nach Fig. 5, so dass auf die vorhergehende Beschreibung verwiesen werden darf.

Wie Fig. 7 zeigt, kann es vorteilhaft sein, sowohl an dem Zulaufverteiler 15 als auch an dem Ablaufverteiler 16 einen Messanschluss 7 und 17 vorzusehen, um den Differenzdruck zwischen Zulaufverteiler 15 und Ablaufverteiler 16 und damit über das gesamte System der mehreren Kühlkörper 2 bestimmen zu können. Zusätzlich ist an jedem Kühlkörper 2 ähnlich wie bei Fig. 6 ein weiterer Messanschluss 6 vorgesehen, insbesondere an der Engstelle bzw. stromab der Engstelle der Querschnittsverjüngung 12. Die Auswerteeinrichtung 10 kann aus der Druckdifferenz zwischen Zulaufverteiler 15 und Ablaufsammler 16 sowie unter Berücksichtigung der Druckwerte an der Engstelle der Querschnittsverjüngungen 12 an den einzelnen Kühlkörpern 2 einerseits die gesamte Durchflussmenge durch die mehreren Kühlkörper 2 und andererseits die individuelle Durchflussmenge durch einen einzelnen Kühlkörper bestimmen.

Im Übrigen entspricht die Ausführung der Fig. 7 der zuvor beschriebenen Ausführung nach Fig. 6, so dass auch hier auf die vorherige Beschreibung verwiesen werden darf.

## Patentansprüche

1. Kühlvorrichtung für leistungselektronische Bauteile, mit zumindest einem Kühlkörper (2) in Form einer Kühlplatte, die mit zumindest einem zu kühlenden leistungselektronischen Bauteil in Berührung steht, sowie einer von einem Kühlmittel durchströmbaren, durch die Kühlplatte führenden Kühlmittelleitung (3), wobei Durchfluss-Bestimmungsmittel zum Bestimmen der durch die Kühlplatte strömenden Durchflussmenge vorgesehen sind, wobei die Kühlmittelleitung (3) in der Kühlplatte eine Querschnittsverjüngung (3) aufweist und zwei Messanschlüsse (6, 7) zum Anschließen eines Differenzdruckmessers (8) zum Messen einer Druckdifferenz (Δ P) an den beiden Messanschlüssen (6, 7) aufweist und die Durchfluss-Bestimmungsmittel eine Auswerteeinrichtung (10) zum Ermitteln der Durchflussmenge aus der genannten Druckdifferenz umfassen, **dadurch gekennzeichnet, dass** einer der Messanschlüsse an oder unmittelbar stromab der Querschnittsverjüngung (3) angeordnet ist.

2. Kühlvorrichtung nach dem vorhergehenden Anspruch, wobei die Querschnittsverjüngung (12) zwischen den beiden Messanschlüssen (6, 7) in Form eines Venturielements (13) ausgebildet ist, das eine Engstelle (13b) bildet, an die stromauf und stromab sich im Durchmesser kontinuierlich verändernde Einlauf- und Auslaufabschnitte (13a, 13 c) anschließen.

3. Kühlvorrichtung nach dem vorhergehenden Anspruch, wobei der genannte eine der Messanschlüsse (6) an der Engstelle (13b) des Venturielements (13) vorgesehen ist und ein anderer der genannten Messanschlüsse (7) stromauf des Einlaufabschnitts (13a) des Venturielements (13), insbesondere in einem noch unverjüngten Abschnitt der Kühlmittelleitung (3) in der Kühlplatte unmittelbar stromauf des Einlaufabschnitts (13a), angeordnet ist.

4. Kühlvorrichtung nach einem der beiden vorhergehenden Ansprüche, wobei das Venturielement (13) ein Einsatzteil bildet, das in die Kühlplatte einsetzbar ist und in der Kühlplatte einen Teil der Kühlmittelleitung durch die Kühlplatte bildet.

5. Kühlvorrichtung nach einem der vorhergehenden Ansprüche, wobei der Differenzdruckmesser (8) zwei an die Messansschlüsse anschließbare Drucksensorelemente (8a, 8b) umfaßt, die mit der Auswerteeinrichtung (10) verbindbar sind, wobei die Auswerteeinrichtung (10) Druckdifferenz-Bestimmungsmittel zum Bestimmen der genannten Druckdifferenz (Δ P) aus den Signalen der beiden Drucksensorelemente (8a, 8b) aufweist.

6. Kühlvorrichtung nach dem vorhergehenden Anspruch, wobei die Drucksensorelemente (8a, 8b) ohne Zwischenschaltung einer Verschlauchung unmittelbar an der Kühlplatte oder einem an der Kühlplatte starr befestigten Sensorhalter montiert und befestigt sind.

7. Kühlvorrichtung nach einem der vorhergehenden Ansprüche, wobei der zumindest eine Kühlkörper einen von mehreren Kühlkörper (2) bildet, wobei die genannten mehreren Kühlkörper an einem gemeinsamen Zuflussverteiler (15) und/oder an einem gemeinsamen Abflusssammler (16) angeschlossen sind.

8. Kühlvorrichtung nach dem vorhergehenden Anspruch, wobei in jedem der Kühlkörper (2) die Kühlmittelleitung jeweils eine Querschnittsverjüngung (13) besitzt und jeweils ein Messanschluss (6) an oder unmittelbar stromab der Querschnittsverjüngung (12) vorgesehen ist, wobei ein weiterer Messanschluss (7) an dem Zulaufverteiler (15) vorgesehen ist, wobei der Differenzdruckmesser (8) einerseits an den Messanschluss (7) am Zulaufverteiler (15) und andererseits an die Messanschlüsse (6) an den Kühlkörpern (2) anschließbar ist und die Auswerteeinrichtung (10) aus der Druckdifferenz zwischen dem Zulaufverteiler (15) und einem jeweiligen Kühlkörper (2) die Durchflussmenge durch den jeweiligen Kühlkörper (2) bestimmt.

9. Kühlvorrichtung nach dem vorhergehenden Anspruch, wobei ein weiterer Messanschluss (17) an dem Ablaufsammler (16) vorgesehen ist, wobei von dem Differenzdruckmesser (8) ein Differenzdruck zwischen dem Zulaufverteiler (15) und dem Ablaufsammler (16) bestimmbar ist und von der Auswerteeinrichtung (10) aus der genannten Druckdifferenz zwischen dem Zulaufverteiler (15) und dem Ablaufsammler (16) sowie den weiteren Druckwerten an den Kühlkörpern (2) einerseits die Einzeldurchflussmengen durch die einzelnen Kühlkörper (2) und andererseits die Gesamtdurchflussmenge durch alle Kühlkörper (2) bestimmbar ist.

10. Kühlvorrichtung nach einem der vorhergehenden Ansprüche, wobei zumindest ein Temperatursensor (11) zum Erfassen der Temperatur des zumindest einen Kühlkörpers (2) und/oder des durch den zumindest einen Kühlkörper (2) strömenden Kühlmittels vorgesehen ist, wobei der genannte Temperatursensor (11) vorteilhafterweise an dem Kühlkörper (2) angebracht ist und mit der Auswerteeinrichtung (10) verbunden ist.

11. Kühlvorrichtung nach dem vorhergehenden Anspruch, wobei die Auswerteeinrichtung (10) derart ausgebildet ist, dass die Durchflussmenge in Abhängigkeit der von dem Temperatursensor (11) bestimmten Temperatur bestimmbar ist.

12. Kühlvorrichtung nach einem der beiden vorhergehenden Ansprüche, wobei bei Verwendung mehrerer Kühlkörper (2) jedem der Kühlkörper (2) zumindest ein Temperatursensor (11) zugeordnet ist.

13. Kühlvorrichtung nach einem der vorhergehenden Ansprüche, wobei die Messanschlüsse (6, 7, 17) als lösbare Steckanschlüsse oder Schraubanschlüsse ausgebildet sind.

14. Kühlvorrichtung nach einem der vorhergehenden Ansprüche, wobei die Auswerteeinrichtung (10) mit mehreren Differenzdruckmessern (8) zum Überwachen mehrerer Kühlkörper (2) verbunden ist.

15. Kühlvorrichtung nach einem der vorhergehenden Ansprüche, wobei die Auswerteeinrichtung (10) über einen Bus (14) mit einer übergeordneten Steuerungsvorrichtung zum Steuern zumindest eines Betriebsparameters der Kühlvorrichtung verbindbar ist.

## Claims

1. A cooling apparatus for power electronic components having at least one cooling body (2) in the form of a cooling plate which is in contact with at least one power electronic component to be cooled and having a coolant line (3) which can be flowed through by a coolant and which leads through the cooling plate, wherein flow determination means are provided for determining the flow quantity flowing through the cooling plate, wherein the coolant line (3) in the cooling plate has a cross-sectional tapering (3) and has two measurement ports (6, 7) for connecting a differential pressure gauge (8) for measuring a pressure difference (A P) at the two measurement ports (6, 7), and the flow determination means comprise an evaluation device (10) for determining the flow quantity from the named pressure difference, **characterized in that** one of the measurement ports is arranged at or directly downstream of the cross-sectional tapering (3).

2. A cooling apparatus in accordance with the preceding claim, wherein the cross-sectional tapering (12) is formed between the two measurement ports (6, 7) in the form of a Venturi element (13) which forms a constriction (13b) which is adjoined by the intake and drain sections (13a, 13c) continuously varying in diameter upstream and downstream.

3. A cooling apparatus in accordance with the preceding claim, wherein the named one of the measurement ports (6) is provided at the constriction (13b) of the Venturi element (13) and another one of the named measurement ports (7) is arranged upstream of the intake section (13a) of the Venturi element (13), in particular in a section, not yet tapered, of the coolant line (3) in the cooling plate directly upstream of the intake section (13a).

4. A cooling apparatus in accordance with one of the two preceding claims, wherein the Venturi element (13) forms an insert part which can be inserted into the cooling plate and forms a part of the coolant line through the cooling plate in the cooling plate.

5. A cooling apparatus in accordance with one of the preceding claims, wherein the differential pressure gauge (8) comprises two pressure sensor elements (8a, 8b) which are connectable to the measurement ports and which are connectable to the evaluation device (10), wherein the evaluation device (10) has pressure difference determination means for determining the named pressure difference (Δ P) from the signals of the two pressure sensor elements (8a, 8b).

6. A cooling apparatus in accordance with the preceding claim, wherein the pressure sensor elements (8a, 8b) are installed and fastened without interposition of a piping directly to the cooling plate or to a sensor holder rigidly fastened to the cooling plate.

7. A cooling apparatus in accordance with one of the preceding claims, wherein the at least one cooling body forms one of a plurality of cooling bodies (2), wherein the named plurality of cooling bodies are connected to common inflow manifold (15) and/or to a common outflow collector (16).

8. A cooling apparatus in accordance with the preceding claim, wherein the coolant line in each of the cooling bodies (2) has a cross-sectional tapering (13) and a respective measurement port (6) is provided at or directly downstream of the cross-sectional tapering (12), wherein a further measurement port (7) is provided at the inflow manifold (15), wherein the differential pressure gauge (8) is connectable to the measurement port (7) at the intake manifold (15), on the one hand, and to the measurement ports (6) at the cooling bodies (2), on the other hand, and the evaluation device (10) determines the flow quantity through the respective cooling body (2) from the pressure difference between the intake manifold (15) and a respective cooling body (2).

9. A cooling apparatus in accordance with the preceding claim, wherein a further measurement port (17) is provided at the drain collector (16), wherein a differential pressure between the intake manifold (15) and the drain collector (16) can be determined by the differential pressure gauge (8) and the individual flow quantities through the individual cooling bodies (2), on the one hand, and the total flow quantity through all the cooling bodies (2), on the other hand, can be determined by the evaluation device (10) from the named pressure difference between the intake manifold (15) and the drain collector (16) as well from the further pressure values at the cooling bodies (2).

10. A cooling apparatus in accordance with one of the preceding claims, wherein at least one temperature sensor (11) for detecting the temperature of the at least one cooling body (2) and/or of the coolant flowing through the at least one cooling body (2) is provided, wherein the named temperature sensor (11) is advantageously attached to the cooling body (2) and is connected to the evaluation device (10).

11. A cooling apparatus in accordance with the preceding claim, wherein the evaluation device (10) is configured such that the flow quantity can be determined in dependence on the temperature determined by the temperature sensor (11).

12. A cooling apparatus in accordance with one of the two preceding claims, wherein, on a use of a plurality of cooling bodies (2), at least one temperature sensor (11) is associated with each of the cooling bodies (2).

13. A cooling apparatus in accordance with one of the preceding claims, wherein the measurement ports (6, 7, 17) are configured as releasable plug-in ports or screw-in ports.

14. A cooling apparatus in accordance with one of the preceding claims, wherein the evaluation device (10) is connected to a plurality of differential pressure gauges (8) to monitor a plurality of cooling bodies (2).

15. A cooling apparatus in accordance with one of the preceding claims, wherein the evaluation device (10) is connectable via a bus (14) to a higher-order control apparatus for controlling at least one operating parameter of the cooling apparatus.

## Revendications

1. Dispositif refroidisseur pour composants électroniques de puissance, comprenant au moins un dissipateur thermique (2) sous la forme d'une plaque de refroidissement, qui est en contact avec au moins un composant électronique de puissance à refroidir, ainsi qu'une conduite de fluide de refroidissement (3) évoluant à travers la plaque de refroidissement et pouvant être traversée par un fluide de refroidissement, des moyens de détermination de débit étant prévus pour déterminer le débit circulant à travers la plaque de refroidissement, la conduite de fluide de refroidissement (3) comportant un rétrécissement de section transversale (3) dans la plaque de refroidissement et comportant deux raccordements de mesure (6, 7) destinés au raccordement d'un manomètre différentiel (8) pour mesurer une différence de pression (Δ P) aux deux raccordements de mesure (6, 7) et les moyens de détermination de débit comprenant un système d'évaluation (10) pour déterminer le débit à partir de ladite différence de pression, **caractérisé en ce qu'**un des raccordements de mesure est disposé sur ou directement en aval du rétrécissement de section transversale (3).

2. Dispositif refroidisseur selon la revendication précédente, dans lequel le rétrécissement de section transversale (12) entre les deux raccordements de mesure (6, 7) est réalisé sous la forme d'un élément Venturi (13), qui forme un resserrement (13b), auquel se rattachent en amont et en aval des sections d'entrée et de sortie (13a, 13c) dont le diamètre change en continu.

3. Dispositif refroidisseur selon la revendication précédente, dans lequel ledit un des raccordements de mesure (6) est prévu sur le resserrement (13b) de l'élément Venturi et un autre desdits raccordements de mesure (7) est disposé en amont de la section d'entrée (13a) de l'élément Venturi (13), en particulier dans une section encore non rétrécie de la conduite de fluide de refroidissement (3) dans la plaque de refroidissement directement en amont de la section d'entrée (13a).

4. Dispositif refroidisseur selon l'une des deux revendications précédentes, dans lequel l'élément Venturi (13) forme une pièce d'insert qui peut être insérée dans la plaque de refroidissement et qui forme dans la plaque de refroidissement une partie de la conduite de fluide de refroidissement à travers la plaque de refroidissement.

5. Dispositif refroidisseur selon l'une des revendications précédentes, dans lequel le manomètre différentiel (8) comprend deux éléments capteurs de pression (8a, 8b) pouvant être raccordés aux raccordements de mesure, qui peuvent être reliés au système d'évaluation (10), le système d'évaluation (10) comportant des moyens de détermination de différence de pression pour déterminer ladite différence de pression (Δ P) à partir des signaux des deux éléments capteurs de pression (8a, 8b).

6. Dispositif refroidisseur selon la revendication précédente, dans lequel les éléments capteurs de pression (8a, 8b) sont montés et fixés sans intercalage de tuyau directement sur la plaque de refroidissement ou sur un support de capteur fixé rigidement sur la plaque de refroidissement.

7. Dispositif refroidisseur selon l'une des revendications précédentes, dans lequel l'au moins un dissipateur thermique forme un de plusieurs dissipateurs thermiques (2), lesdits plusieurs dissipateurs thermiques étant raccordés à un répartiteur d'admission (15) commun et/ou à un collecteur d'écoulement (16) commun.

8. Dispositif refroidisseur selon la revendication précédente, dans lequel, dans chacun des dissipateurs thermiques (2), la conduite de fluide de refroidissement possède respectivement un rétrécissement de section transversale (13), et un raccordement de mesure (6) est prévu respectivement sur ou directement en aval du rétrécissement de section transversale (12), un autre raccordement de mesure (7) étant prévu sur le répartiteur d'admission (15), le manomètre différentiel (8) pouvant être raccordé d'une part au raccordement de mesure (7) du répartiteur d'admission (15) et d'autre part aux raccordements de mesure (6) des dissipateurs thermiques (2) et le système d'évaluation (10) déterminant le débit à travers le dissipateur thermique (2) respectif à partir de la différence de pression entre le répartiteur d'admission (15) et un dissipateur thermique (2) respectif.

9. Dispositif refroidisseur selon la revendication précédente, dans lequel un autre raccordement de mesure (17) est prévu sur le collecteur d'écoulement (16), une pression différentielle entre le répartiteur d'admission (15) et le collecteur d'écoulement (16) pouvant être déterminée par le manomètre différentiel (8) et d'une part les débits individuels à travers chaque dissipateur thermique (2) et d'autre part le débit total à travers tous les dissipateurs thermiques (2) pouvant être déterminés par le système d'évaluation (10) à partir de ladite différence de pression entre le répartiteur d'admission (15) et le collecteur d'écoulement (16) ainsi que des autres valeurs de pression des dissipateurs thermiques (2).

10. Dispositif refroidisseur selon l'une des revendications précédentes, dans lequel au moins un capteur de température (11) est prévu pour détecter la température de l'au moins un dissipateur thermique (2) et/ou du fluide de refroidissement circulant à travers l'au moins un dissipateur thermique (2), ledit capteur de température (11) étant, de manière avantageuse, monté sur le dissipateur thermique (2) et relié au système d'évaluation (10).

11. Dispositif refroidisseur selon la revendication précédente, dans lequel le système d'évaluation (10) est conçu de telle manière que le débit peut être déterminé en fonction de la température déterminée par le capteur de température (11).

12. Dispositif refroidisseur selon l'une des deux revendications précédentes, dans lequel, lors de l'utilisation de plusieurs dissipateurs thermiques (2), au moins un capteur de température (11) est associé à chacun des dissipateurs thermiques (2).

13. Dispositif refroidisseur selon l'une des revendications précédentes, dans lequel les raccordements de mesure (6, 7, 17) sont réalisés sous la forme de raccordements enfichables ou raccordements à vis pouvant être détachés.

14. Dispositif refroidisseur selon l'une des revendications précédentes, dans lequel le système d'évaluation (10) est relié à plusieurs manomètres différentiels (8) pour la surveillance de plusieurs dissipateurs thermiques (2).

15. Dispositif refroidisseur selon l'une des revendications précédentes, dans lequel le système d'évaluation (10) peut être relié à un dispositif de commande de niveau supérieur par le biais d'un bus (14) pour la commande d'au moins un paramètre de fonctionnement du dispositif refroidisseur.
